(19) Europäisches Patentamt
European Patent Office
Office européen des brevets

(11) **EP 1 731 583 A1**

(12) **EUROPEAN PATENT APPLICATION**
published in accordance with Art. 158(3) EPC

(43) Date of publication:
**13.12.2006 Bulletin 2006/50**

(51) Int Cl.:
*C09K 11/02* (2006.01)    *C09K 11/08* (2006.01)
*H05B 33/12* (2006.01)    *H05B 33/14* (2006.01)

(21) Application number: **05720496.8**

(22) Date of filing: **10.03.2005**

(86) International application number:
**PCT/JP2005/004225**

(87) International publication number:
**WO 2005/097939 (20.10.2005 Gazette 2005/42)**

(84) Designated Contracting States:
**DE FR GB**

(30) Priority: **30.03.2004 JP 2004100577**

(71) Applicant: **IDEMITSU KOSAN CO., LTD.**
**Tokyo 100-8321 (JP)**

(72) Inventor: **KUMA, Hitoshi**
**2990293 (JP)**

(74) Representative: **Gille Hrabal Struck Neidlein Prop Roos**
**Brucknerstrasse 20**
**40593 Düsseldorf (DE)**

(54) **FLUORESCENT CONVERSION MEDIUM AND COLOR LIGHT EMITTING DEVICE**

(57)    A fluorescent conversion medium (1) including: fluorescent particles (12) comprising semiconductor nanocrystals, the particles absorbing visible light to emit fluorescence of a different wavelength, a transparent medium (11) holding the fluorescent particles dispersed therein, and satisfying $0.4 < C \cdot d/r^3 < 5.0$ wherein r is the average diameter (unit: nm) of the fluorescent particles (12), d is the film thickness (unit: $\mu$m) of the fluorescent conversion medium (1), and C is the volume ratio (unit: vol%) of the fluorescent particles (12) to the fluorescent conversion medium.

FIG.1

Transmitted light + Fluorescence

1

11

12

Excitation light

**Description**

TECHNICAL FIELD

The invention relates to a fluorescent conversion medium and a color light emitting apparatus using the fluorescent conversion medium. More particularly, the invention relates to a highly efficient fluorescent conversion medium in which semiconductor nanocrystals are dispersed, and a color light emitting apparatus using the fluorescent conversion medium and a light source which emits visible light.

BACKGROUND ART

A fluorescent conversion medium which converts the wavelength of light from a light source using a fluorescent material has been used in various fields including the electronic display field.
For example, an electroluminescent (hereinafter may be abbreviated as "EL") device has been disclosed which includes an organic electroluminescent material section which emits blue light or blue green light, and a fluorescent material section which absorbs light from the emitting layer and emits visible fluorescence of at least one color ranging from blue green to red (see patent document 1, for example).
This method uses a blue light source and obtains the three primary colors by converting blue light using a fluorescent conversion medium. In the fluorescent conversion medium, fluorescent dyes are excited by applying blue light to obtain green light and red light having wavelengths longer than that of the blue light.
As the fluorescent material used for the fluorescent conversion medium, an organic fluorescent dye and an organic fluorescent pigment have been generally used. For example, a red fluorescent conversion medium has been disclosed in which a rhodamine fluorescent pigment and a fluorescent pigment exhibiting an absorption in the blue region and inducing energy transfer or reabsorption into the rhodamine fluorescent pigment are dispersed in a light-transmitting medium (see patent document 2, for example).
However, these technologies have the following problems.

1. In order to improve the conversion efficiency of the fluorescent conversion medium to enhance the intensity (fluorescence intensity) of the converted light, it is necessary to cause the fluorescent conversion medium to sufficiently absorb light from the light source. When the concentration of the organic fluorescent dye in the fluorescent conversion medium is increased in order to achieve sufficient absorption, since the organic fluorescent dyes are associated in the film, concentration quenching inevitably occurs in which the energy absorbed from the light source moves to the adjacent dye, whereby a high fluorescence quantum yield cannot be obtained.

2. When a reactive resin such as a photo-curable resin or a heat-curable resin is used as the light-transmitting medium, a reaction occurs between the reactive component in the resin and the organic fluorescent dye, whereby the dye is decomposed or changes in structure. Therefore, the fluorescence intensity of the fluorescent conversion medium may deteriorate due to a process of applying ultraviolet rays or a process of curing the material at a high temperature (e.g. 200°C) during the formation of the fluorescent conversion medium. Moreover, when excitation light is continuously applied to the fluorescent conversion medium during continuous drive of the light emitting apparatus, the fluorescence intensity of the fluorescent conversion medium deteriorates with time.

Patent document 3 and patent document 4 disclose methods for preventing deterioration of the fluorescence intensity of the fluorescent conversion medium. In the technologies disclosed in these patent documents, an antioxidant, a light stabilizer, and an additive for capturing energy are added to a fluorescent conversion medium resin composition. However, the effects of these technologies are not necessarily sufficient .
In order to solve the above-described problems when using the organic fluorescent dye as the fluorescent material for the fluorescent conversion medium, patent document 5 proposes technology of forming a full color organic EL device using semiconductor nanocrystals. Patent document 6 discloses technology of realizing a highly efficient white LED by combining a fluorescent conversion medium containing semiconductor nanocrystals dispersed therein with an LED.
In the patent document 5, a film in which CdS, CdSe, or CdTe (semiconductor nanocrystals) is dispersed in a light-transmitting resin is used as the fluorescent conversion medium and combined with an organic EL device which emits blue light having a peak wavelength of 450 nm to obtain red light and green light. The color conversion such as conversion into red and green is controlled by controlling the particle diameter of the semiconductor nanocrystals.
The inventor of the invention focused on the technology disclosed in the patent document 5, and studied the combination of a fluorescent conversion medium using the semiconductor nanocrystals and an organic EL device. As a result, the inventor found that the fluorescence conversion efficiency is not improved to the level expected from the fluorescence quantum yield of the nanocrystals, even if the concentration of the semiconductor nanocrystals in the fluorescent conversion medium is increased in order to allow the fluorescent conversion medium to sufficiently absorb light from the organic EL device.

[Patent document 1] JP-A-3-152897
[Patent document 2] JP-A-8-286033
[Patent Document 3] JP-A-2000-256565
[Patent Document 4] JP-A-2003-231450
[Patent document 5] United States Patent No. 6,608,439
[Patent document 6] United States Patent No. 6,501,091

The invention was achieved in view of the above-described problems. An object of the invention is to provide a fluorescent conversion medium which exhibits a high fluorescence conversion efficiency and deteriorates with time to only a small extent by allowing the semiconductor nanocrystals to efficiently exhibit fluorescence conversion capabilities, and a color light emitting apparatus using the fluorescent conversion medium.

DISCLOSURE OF THE INVENTION

The inventor investigated the cause of the above phenomenon in order to achieve the above object. As a result, the inventor found that the basic causes are (1) the high refractive index of the semiconductor nanocrystals and (2) self-absorption resulting from the absorption spectrum and the fluorescence spectrum which overlap to a small extent. A semiconductor material represented by CdSe exhibits a refractive index as high as about 2. 5 to 4 in the visible region. On the other hand, a transparent resin used as the dispersion medium for the semiconductor nanocrystals generally has a refractive index of 1.4 to 1.6. Therefore, when the concentration of the semiconductor nanocrystals in the fluorescent conversion medium is increased in order to allow the fluorescent conversion medium to sufficiently absorb light from the organic EL device, the refractive index of the fluorescent conversion medium gradually increases. The inventor investigated the reason why the fluorescence conversion efficiency decreases with an increase of the refractive index. As a result, the inventor has found that fluorescence from the fluorescent conversion medium is totally reflected at the interface between the fluorescent conversion medium and air and is confined in the fluorescent conversion medium, thereby decreasing the fluorescence conversion efficiency.
The absorption spectrum and the fluorescence spectrum of the semiconductor nanocrystal overlap to a small extent. Specifically, the semiconductor nanocrystals absorb fluorescence emitted therefrom. Therefore, the amount of self-absorption increases to a large extent as the nanocrystal concentration in the fluorescent conversion medium increases, whereby the fluorescence conversion efficiency decreases.
The inventor studied various types and concentrations of semiconductor nanocrystals and found that there is an optimum range for an enhanced fluorescent conversion efficiency by suppressing the light confining effect and fluorescence self-absorption.
According to the invention, the following fluorescent conversion medium and color light emitting apparatus.

1. A fluorescent conversion medium comprising:

fluorescent particles comprising semiconductor nanocrystals, the particles absorbing visible light to emit fluorescence of a different wavelength,
a transparent medium holding the fluorescent particles dispersed therein, and
satisfying $0.4 < C \cdot d/r^3 < 5.0$

wherein r is the average diameter (unit: nm) of the fluorescent particles, d is the film thickness (unit: $\mu$m) of the fluorescent conversion medium, and C is the volume ratio (unit: vol%) of the fluorescent particles to the fluorescent conversion medium.
2. The fluorescent conversion medium according to 1, wherein a bulk material used for the semiconductor nanocrystals has a band gap of 1.0 to 3.0 eV at 20°C.
3. The fluorescent conversion medium according to 1 or 2, wherein the fluorescent particles are core/shell semiconductor nanocrystals comprising a core particle made of a semiconductor nanocystal and a shell layer made of a second semiconductor material having a larger band gap than the band gap of the semiconductor material used for the core particle.

4. The fluorescent conversion medium according to 3, wherein the transparent medium is a resin, and the surface of the shell layer is subjected to a compatibility-treatment to enhance the affinity to the resin.

5. A fluorescent conversion substrate comprising;

a transparent support substrate, and

a fluorescent conversion part provided on the transparent support substrate, the part comprising the fluorescent conversion medium according to 1.

6. A color light emitting apparatus comprising;

a light source emitting visible light, and

a fluorescent conversion part receiving the light from the light source to emit fluorescence of a longer wavelength, the part comprising the fluorescent conversion medium according to any one of 1 to 4.

7 . The color light emitting apparatus according to 6, wherein the fluorescent conversion part is a multilayer structure of the fluorescent conversion medium and a color filter, the color filter transmitting light in a wavelength region of the fluorescence from the fluorescent conversion medium, and cutting off light in the other wavelength region.

8. A color light emitting apparatus comprising;

a light source emitting at least blue light, and

a fluorescent conversion part comprising pixels of red (R), green (G) and blue (B), the part receiving light from the light source to emit red, green or blue light,

the pixels of red (R) and green (G) comprising the fluorescent conversion medium according to any one of 1 to 4, and

the pixel of blue (B) comprising a color filter.

9. A color light emitting apparatus comprising;

a light source emitting at least blue light, and

the fluorescent conversion medium according to any one of 1 to 4, receiving light from the light source to emit light in at least one color ranging from green to red and transmit part of the blue light emitted from the light source.

10. The color light emitting apparatus according to any one of 6 to 9, wherein the light source is an organic electroluminescent device,

the organic electroluminescent device comprising,

a first light-reflective electrode,

a second light-transparent electrode, and

an organic luminescent medium comprising an organic emitting layer between the first and second electrodes.

Since the fluorescent conversion medium according to the invention allows the semiconductor nanocrystals to efficiently exhibit fluorescence conversion capabilities, the conversion film exhibits a high fluorescence conversion efficiency. Moreover, since an organic fluorescent dye and an organic fluorescent pigment are not used for the fluorescent conversion medium, the fluorescent conversion medium deteriorates with time to only a small extent. Therefore, a color light emitting apparatus using this fluorescent conversion medium shows only a small change in color with time and exhibits a stable color display function for a long time.

BRIEF DESCRIPTION OF THE DRAWINGS

FIG. 1 is a schematic view showing the cross section of a fluorescent conversion medium according to the invention.
FIG. 2 is a schematic view showing the state in which a semiconductor nanocrystal emits fluorescence.
FIG. 3 is a view showing the relationship between the particle diameter and the shift of the fluorescence wavelength of a semiconductor material.
FIG. 4 is a view illustrative of fluorescent components confined in the fluorescent conversion medium.
FIG. 5 is a view showing a relative decrease in the amount of fluorescent components released to the outside from the fluorescent conversion medium with a change in the refractive index of the fluorescent conversion medium.
FIG. 6 is a view showing the absorption spectrum and the fluorescence spectrum of a dilute CdSe nanocrystal particle dispersion in toluene.
FIG. 7A is a view showing the relationship between the value "$C \cdot d/r^3$" and the fluorescence intensity when a fluorescent conversion medium is excited using monochromatic light having a wavelength of 470 nm in the case where the effects of the refractive index of the semiconductor nanocrystal and the effects of self-absorption are not taken into consideration.

FIG. 7B is a view showing the relationship between the value "C·d/r³" and the fluorescence intensity when a fluorescent conversion medium is excited using monochromatic light having a wavelength of 470 nm in the case where the effects of the refractive index of the semiconductor nanocrystal are taken into consideration, but the effects of self-absorption are not taken into consideration.

FIG. 7C is a view showing the relationship between the value "C·d/r³" and the fluorescence intensity when a fluorescent conversion medium is excited using monochromatic light having a wavelength of 470 nm in the case where the effects of the refractive index of the semiconductor nanocrystal are not taken into consideration, but the effects of self-absorption are taken into consideration.

FIG. 7D is a view showing the relationship between the value "C·d/r³" and the fluorescence intensity when a fluorescent conversion medium is excited using monochromatic light having a wavelength of 470 nm in the case where the effects of the refractive index of the semiconductor nanocrystal and the effects of self-absorption are taken into consideration.

FIG. 8 is a schematic view showing a color light emitting apparatus according to a second embodiment of the invention.

FIG. 9 is a schematic view of an organic EL device.

FIG. 10 is a schematic view showing a color light emitting apparatus according to a third embodiment of the invention.

FIG. 11 is a schematic view showing a color light emitting apparatus according to a fourth embodiment of the invention.

FIG. 12 is a schematic view showing a color light emitting apparatus according to a fifth embodiment of the invention.

BEST MODE FOR CARRYING OUT THE INVENTION

[First embodiment]

A fluorescent conversion medium according to a first embodiment of the invention is described below in detail.

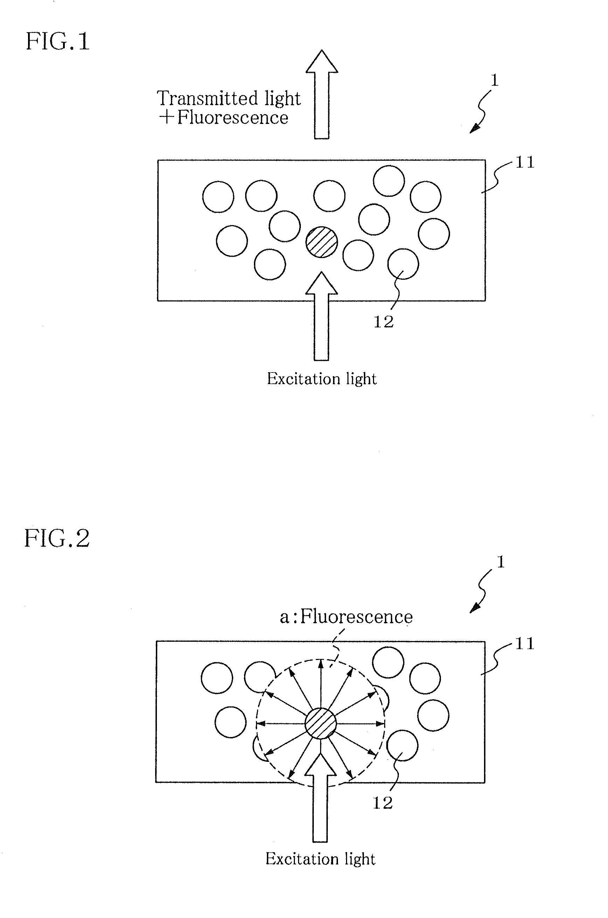

FIG. 1 is a schematic view showing the cross section of the fluorescent conversion medium.

A fluorescent conversion medium 1 is a film in which fluorescent particles 12 are dispersed in a transparent medium 11. The fluorescent conversion medium 1 absorbs excitation light from a light source (not shown) and isotropically emits light (fluorescence) having a wavelength longer than that of the light from the light source.

FIG. 2 is a schematic view showing the state in which a fluorescent particle isotropically emits fluorescence.

In FIG. 1, the fluorescent particle indicated by the slanted lines absorbs excitation light to isotropically emit fluorescence. The light (fluorescence) converted by the fluorescent conversion medium 1 and the excitation light which has passed through the film without being converted are emitted to the outside of the fluorescent conversion medium 1.

The configuration of the fluorescent conversion medium is described below.

1. Fluorescent particles

The fluorescent particle used in the invention includes a nanocrystal which is formed by forming a crystal of a semiconductor material into ultrafine particles with a nanometer size. As the semiconductor nanocrystal, a particle which absorbs visible light and emits fluorescence having a wavelength longer than that of the absorbed light may be used.

The functions of the semiconductor nanocrystals are described below. The semiconductor material has a band gap of about 0.5 to 4.0 eV at room temperature in the state of a bulk material ("bulk material" means a material which is not formed into particles), as disclosed in JP-T-2002-510866. When forming particles using the above material and reducing the particle diameter of the particles to a nanometer level, electrons in the semiconductor are confined in the nanocrystal. As a result, the nanocrystal exhibits a higher band gap.

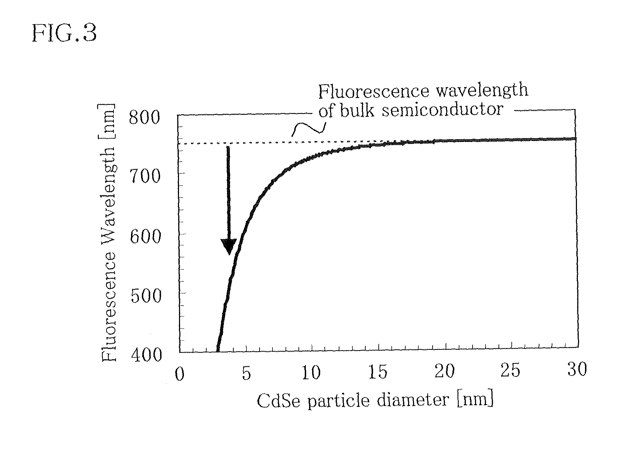

FIG. 3 shows the relationship between the particle diameter and the emission wavelength of a semiconductor material.

FIG. 3 shows the relationship between the particle diameter and the emission wavelength of a cadmium selenide (CdSe) particle. This relationship was obtained by theoretical calculations.

A CdSe bulk crystal has a band gap of 1.74 eV at room temperature. This corresponds to a fluorescence wavelength of about 750 nm in the near-infrared region. When the diameter of the CdSe particle is reduced to 20 nm or less, the fluorescence wavelength of the CdSe particle is gradually shifted to a wavelength shorter than 750 nm. In particular, the fluorescence wavelength is shifted to a large extent when the particle diameter is reduced to less than 10 nm. For example, when the diameter of the CdSe particle is 5 nm, the CdSe particle emits fluorescence having a wavelength of 630 nm (pure red). When the diameter of the CdSe particle is 4 nm, the CdSe particle emits fluorescence having a wavelength of 530 nm (green). A fluorescent conversion medium which absorbs visible light corresponding to the desired wavelength and emits fluorescence having a longer wavelength can be realized by controlling the diameter of the semiconductor particles.

In theory, the band gap increases in inverse proportion to the square of the diameter of the semiconductor particle. Therefore, the band gap can be controlled by controlling the diameter of the semiconductor particle. This semiconductor absorbs light having a wavelength shorter than the wavelength corresponding to the band gap, and emits fluorescence having a wavelength corresponding to the band gap.

Semiconductor particles with a diameter of 20 nm or less, and preferably 10 nm or less are suitably used, since such semiconductor particles efficiently absorb visible light without scattering and emit fluorescence having a longer wavelength.

The band gap of a bulk semiconductor is preferably 1.0 to 3.0 eV. If the band gap is less than 1.0 eV, the resulting nanocrystal exhibits a fluorescence wavelength which changes to a large extent due to a change in the particle diameter, whereby the production management becomes difficult. If the band gap exceeds 3.0 eV, since the resulting nanocrystal emits only fluorescence having a wavelength shorter than that in the near ultraviolet region, it is difficult to use such a material for a color light emitting apparatus.

The band gap of a bulk semiconductor is a value obtained by measuring the light absorption of a bulk semiconductor sample at 20°C and determining the photon energy corresponding to the wavelength at which the absorption coefficient is significantly increased.

As examples of the semiconductor material, crystals formed of group IV elements (group of the periodic table (long period) ; hereinafter the same), group IIa element-group VIb element compounds, group IIb element-group VIb element compounds, group IIIa element-group Vb element compounds, and group IIIb element-group Vb element compounds can be given.

Specific examples of the semiconductor material include crystals of Si, Ge, MgS, ZnS, MgSe, ZnSe, AlP, GaP, AlAs, GaAs, CdS, CdSe, InP, InAs, GaSb, AlSb, ZnTe, CdTe, and InSb, and mixed crystals of these elements or compounds. Of these, AlP, GaP, Si, ZnSe, AlAs, GaAs, CdS, InP, ZnTe, AlSb, and CdTe are preferable. In particular, ZnSe, GaAs, CdS, InP, ZnTe, and CdTe (direct transition semiconductors) are still more preferable from the viewpoint of high luminous efficiency.

The semiconductor nanocrystals may be produced us ing a known method such as that disclosed in United States Patent No. 6,501,091. United States Patent No. 6,501,091 discloses a production example in which a precursor solution prepared by mixingtrioctylphosphine (TOP) with trioctyl phosphine selenide and dimethylcadmium is added to trioctyl phosphine oxide (TOPO) heated at 350°C.

As another example of the semiconductor nanocrystal used in the invention, a core/shell semiconductor nanocrystal can be given. For example, the core/shell semiconductor nanocrystal has a structure in which the surface of a core particle formed of CdSe (band gap: 1.74 eV) is coated (covered) with a shell formed of a semiconductor material having a large band gap such as ZnS (band gap: 3.8 eV). This facilitates to confine generated electrons in the core particle.

The core/shell semiconductor nanocrystal may be produced using a known method such as that disclosed in United States Patent No. 6,501,091. For example, a CdSe core/ZnS shell structure may be produced by adding a precursor solution prepared by mixing TOP with diethylzinc and trimethylsilyl sulfide to a TOPO solution heated at 140°C in which CdSe core particles are dispersed.

In the above specific examples of the semiconductor nanocrystal, a phenomenon tends to occur in which S, Se, or the like is removed by an active component (e.g. unreacted monomer or water) in a transparent medium (described later) to damage the crystal structure of the nanocrystal, whereby the fluorescent properties disappear. In order to prevent this phenomenon, the surface of the semiconductor nanocrystal may be modified with a metal oxide such as silica, an organic substance, or the like.

In order to improve dispersibility in a matrix resin described later, the surface of the particle may be modified or coated with a long-chain alkyl group, phosphoric acid, a resin, or the like.

The above fluorescent particles may be used either individually or in combination of two or more.

2. Transparent medium

The transparent medium is a medium in which the semiconductor nanocrystals are dispersed and which holds the semiconductor nanocrystals. As the transparent medium, a transparent material such as glass or a transparent resin may be used. In particular, a resin such as a non-curable resin, heat-curable resin, or photocurable resin is suitably used from the viewpoint of processability of the fluorescent conversion medium.

As specific examples of such a resin, in the form of either an oligomer or a polymer, a melamine resin, a phenol resin, an alkydresin, an epoxy resin, a polyurethane resin, amaleicresin, a polyamide resin, polymethyl methacrylate, polyacrylate, polycarbonate, polyvinyl alcohol, polyvinylpyrrolidone, hydroxyethylcellulose, carboxymethylcellulose, copolymers containing monomers forming these resins, and the like can be given.

A photocurable resin may be used in order to pattern the fluorescent conversion medium. As the photo-curable resin, a photo-polymerizable resin such as an acrylic acid or methacrylic acid based resin containing a reactive vinyl group, a photo-crosslinkable resin which generally contains a photo-sensitizer, such as polyvinyl cinnamate, or the like may be used. A heat-curable resin may be used when the photo-sensitizer is not used.

When forming a full color display, a fluorescent conversion medium is formed in which fluorescent material layers are separately disposed in a matrix. Therefore, a photo-curable resin which allows application of photolithography is preferably used as the matrix resin (transparent medium).

These matrix resins may be used individually or in combination of two or more.

3. Production of fluorescent conversion medium

The fluorescent conversion medium is formed using a liquid dispersion prepared by mixing and dispersing the fluorescent particles and the matrix resin (transparent medium) using a known method such as milling or ultrasonic dispersion. In this case, a good solvent for the matrix resin may be used. A film is formed on a supporting substrate using the resulting fluorescent particle liquid dispersion by a known film formation method such as spin coating or screen printing to produce a fluorescent conversion medium.

Note that a UV absorber, dispersant, leveling agent, and the like may be added to the fluorescent conversion medium in addition to the fluorescent particles and the transparent medium insofar as the object of the invention is not impaired.

In the invention, when the average diameter (unit: nm) of the fluorescent particles is indicated by r, the film thickness (unit: $\mu$m) of the fluorescent conversion medium is indicated by d, and the volume ratio (unit: vol%) of the fluorescent particles to the fluorescent conversion medium is indicated by C, the film thickness of the fluorescent conversion medium and the ratio of the fluorescent particles to the fluorescent conversion medium are selected so that "0.4 < $C \cdot d/r^3$ < 5.0" is satisfied. The reasons therefor are described below in detail.

A semiconductor material represented by CdSe has a refractive index as high as about 2.5 to 4 in the visible region. On the other hand, the transparent medium used as the dispersion medium for the semiconductor nanocrystals generally has a refractive index of 1.4 to 1.6. Therefore, when the concentration of the semiconductor nanocrystals in the fluorescent conversion medium is increased in order to allow the fluorescent conversion medium to sufficiently absorb light from a light source, the refractive index of the fluorescent conversion medium gradually increases, whereby the amount of fluorescent components confined in the fluorescent conversion medium is increased.

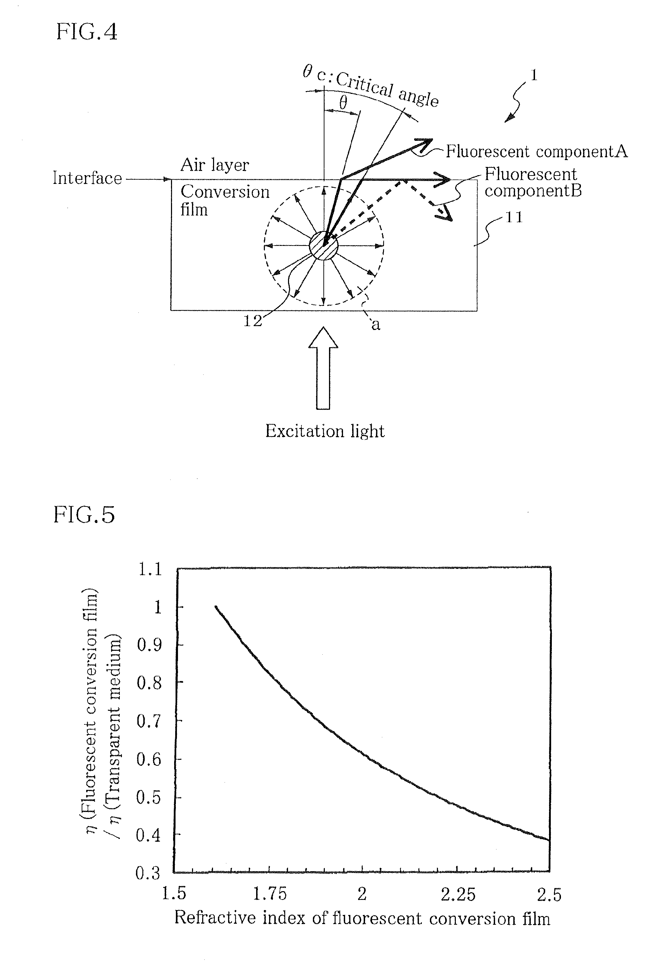

The above phenomenon is described below with reference to FIG. 4.

FIG. 4 is a view illustrative of fluorescent components confined in the fluorescent conversion medium.

As shown in FIG. 4, fluorescence is isotropically emitted from the fluorescent particle 12 in the fluorescent conversion medium 1. The refractive index of the fluorescent conversion medium 1 is referred to as n. Consider the case of observing the fluorescence intensity from an air layer outside the fluorescent conversion medium 1 while focusing on a fluorescent component emitted from the fluorescent particle 12 in the direction at an angle of $\theta$ with respect to the direction normal to the surface of the fluorescent conversion medium.

When light passes through the interface between layers having different refractive indices, the light is refracted at the interface. When the angle $\theta$ of light exceeds a specific value, the light is totally reflected at the interface. Therefore, the light is confined inside the interface and is not emitted to the outside of the film. A critical angle $\theta_c$ at which light is totally reflected at the interface is defined by the following expression (1). Note that the refractive index of the air layer is about 1.0.

$$\sin\theta_c = 1/n \qquad (1)$$

As indicated by the expression (1), the critical angle $\theta_c$ changes depending on the refractive index n of the fluorescent conversion medium 1. Specifically, the critical angle $\theta_c$ decreases as the refractive index increases.

When the angle $\theta$ of the fluorescent component is smaller than the critical angle $\theta_c$ ("fluorescent component A" in FIG. 4), the fluorescent component is reflected to a certain extent at the interface between the fluorescent conversion medium and the air layer, and the remaining fluorescence passes through the interface and is emitted to the outside of the film. On the other hand, when the angle $\theta$ of the fluorescent component is greater than the critical angle $\theta_c$ ("fluorescent component B" in FIG. 4), the fluorescent component is totally reflected at the interface between the fluorescent conversion medium and the air layer and is confined in the film.

Specifically, only the fluorescent component emitted in the solid angle range determined by the critical angle $\theta_c$ within the total solid angle $4n$ is emitted to the outside of the fluorescent conversion medium 1. The ratio $\eta$ of the fluorescent component is defined by the following expression.

$$\eta = 1 - (1 - n^{-2})^{1/2} \qquad (2)$$

FIG. 5 is a view showing the relationship between the refractive index of the fluorescent conversion medium and the amount of fluorescent component released to the outside of the fluorescent conversion medium. FIG. 5 illustrates the case where the refractive index of the transparent medium is 1.6 and the amount [η (fluorescent conversion medium) /η (transparent medium)] of fluorescent component emitted to the outside of the film is "1" when the refractive index of the fluorescent conversion medium is 1.6.

As is clear from FIG. 5, the amount of fluorescent component emitted to the outside of the film significantly decreases as the refractive index of the fluorescent conversion medium increases.

When dispersing nano-sized particles formed of a material with a high refractive index in a transparent medium with a low refractive index, the refractive index of the film increases depending on the volume ratio C (unit: %) of the particles in the film.

The fluorescence intensity inside the fluorescent conversion medium increases as the concentration of the fluorescent particles in the film increases. The fluorescence intensity is saturated and does not increase at a certain concentration or more since excitation light is sufficiently absorbed.

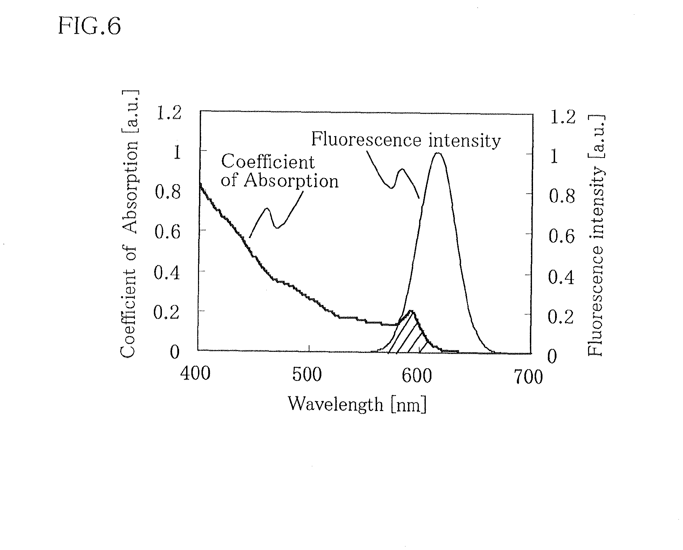

As a typical example of the absorption spectrum and the fluorescence spectrum of the semiconductor nanocrystal, FIG. 6 shows measurement results for the absorption spectrum and the fluorescence spectrum of a dilute dispersion of CdSe nanocrystal particles in toluene. As indicated by the slanted lines in FIG. 6, the absorption spectrum and the fluorescence spectrum partially overlap. Specifically, the semiconductor nanocrystal absorbs fluorescence emitted therefrom (self-absorption). Therefore, the amount of self-absorption increases to a large extent as the nanocrystal concentration in the fluorescent conversion medium increases, whereby the fluorescence conversion efficiency decreases.

The inventor examined parameters which affect the effects the refractive index of the semiconductor nanocrystal and the effects of self-absorption using plural types of semiconductor nanocrystals with different particle diameters and light absorption coefficients. As a result, the inventor has found that the following value is important; the value obtained by dividing the product of the volume ratio C (%) of the fluorescent particles and the film thickness d ($\mu$m) of the fluorescent conversion medium by the cube of the diameter r (nm) of the fluorescent particles, that is, the value "$C \cdot d/r^3$" proportional to the number of fluorescent particles present in the thickness direction of the fluorescent conversion medium.

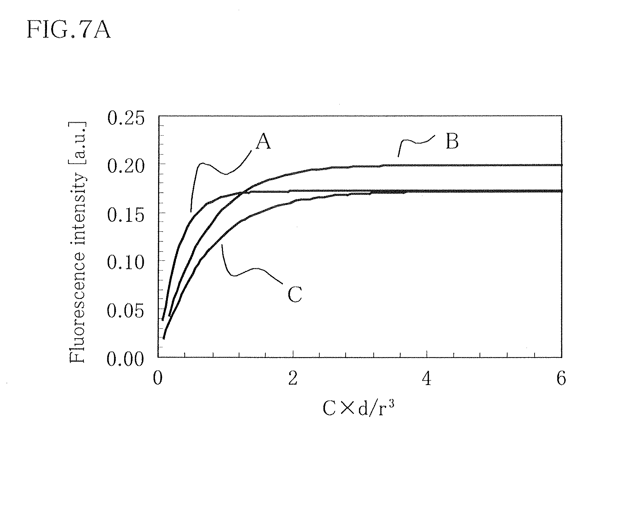

FIGS. 7A to 7D are views showing the relationship between the value "$C \cdot d/r^3$" and the fluorescence intensity when fluorescent conversion media using three semiconductor nanocrystal materials with different particle diameters and light absorption coefficients are excited using monochromatic light having a wavelength of 470 nm.

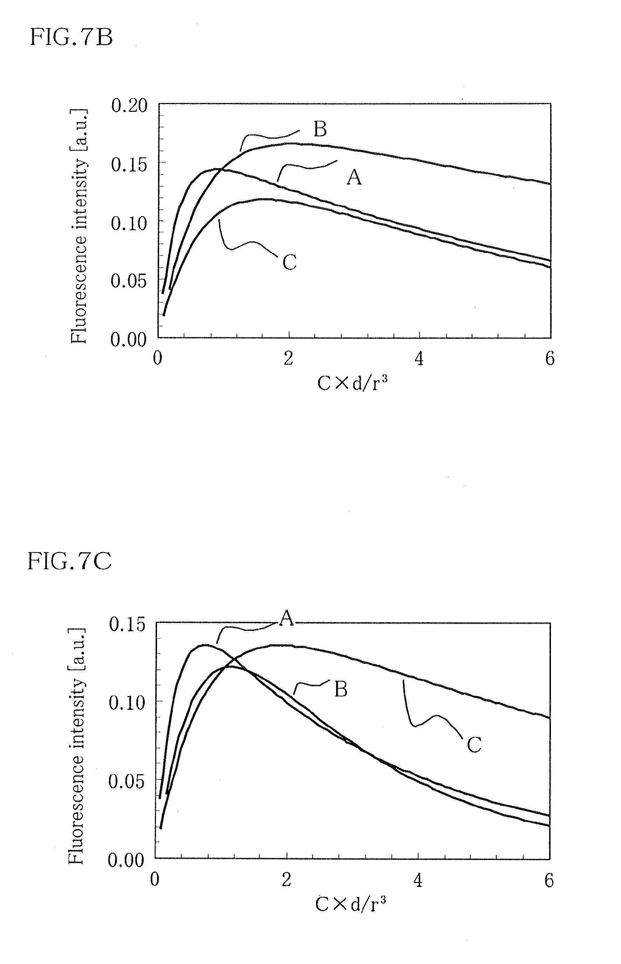

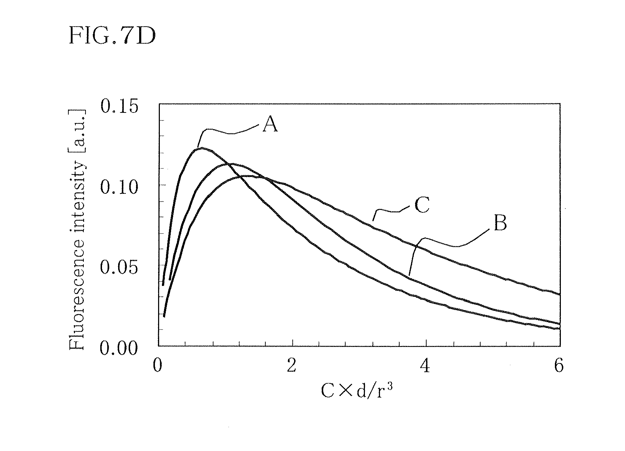

FIG. 7A illustrates the case where the effects of the refractive index of the semiconductor nanocrystal and the effects of self-absorption are not taken into consideration. FIG. 7B illustrates the case where the effects of the refractive index of the semiconductor nanocrystal are taken into consideration, but the effects of self-absorption are not taken into consideration. FIG. 7C illustrates the case where the effects of the refractive index of the semiconductor nanocrystal are not taken into consideration, but the effects of self-absorption are taken into consideration. FIG. 7D illustrates the case where the effects of the refractive index of the semiconductor nanocrystal and the effects of self-absorption are taken into consideration. These relationships were determined by theoretical calculations. Symbols A, B, and C shown in FIGS. 7A to 7D indicate the semiconductor nanocrystals used for calculations. Table 1 shows the specific materials, particle diameters, and absorption coefficients.

TABLE 1

| | | Material | Particle diameter (nm) | Absorption coefficient at excitation wavelength (470 nm) ($\times 10^5$ M$^{-1}$·cm$^{-1}$) |
|---|---|---|---|---|
| | A | CdSe | 5.2 | 11.3 |
| | B | CdSe | 4.0 | 5.0 |
| | C | InP | 4.9 | 4.3 |

FIG. 7A illustrates the case where the effects of the refractive index of the semiconductor nanocrystal and the effects of self-absorption are not taken into consideration. The fluorescence intensity is saturated at a specific value when the value "$C \cdot d/r^3$" exceeds a specific value. This is because excitation light is sufficiently absorbed when the amount of particles becomes equal to or greater than a specific value. As shown in FIG. 7A, the fluorescence intensity is generally saturated when the value "$C \cdot d/r^3$" exceeds five, although the value varies depending on the type and the particle diameter of the semiconductor nanocrystals. Specifically, it is useless to add the semiconductor nanocrystals to the fluorescent conversion medium in such an amount that the value "$C \cdot d/r^3$" exceeds five.

FIG. 7B illustrates the case where the effects of the refractive index of the semiconductor nanocrystal are taken into consideration, but the effects of self-absorption are not taken into consideration. As described above, the refractive index of the fluorescent conversion medium gradually increases as the volume ratio of the semiconductor nanocrystals increases, whereby fluorescence produced in the medium is confined in the medium. As shown in FIG. 7B, the fluorescence intensity is decreased to a large extent when the value "C·d/r³" exceeds five, although the value varies depending on the type and the particle diameter of the semiconductor nanocrystals.

FIG. 7C illustrates the case where the effects of the refractive index of the semiconductor nanocrystal are not taken into consideration, but the effects of self-absorption are taken into consideration. As shown in FIG. 7C, the fluorescence intensity is decreased to a large extent when the value "C·d/r³" exceeds five, although the value varies depending on the type, particle diameter, and particularly light absorption coefficient of the semiconductor nanocrystals.

FIG. 7D illustrates the case where both the effects are taken into consideration. As shown in FIG. 7D, the fluorescence intensity is decreased to a large extent due to the effects of the refractive index and self-absorption when the value "C·d/r³" exceeds five.

If the value "C·d/r³" is less than 0.4, since the amount of fluorescent particles is too small, a practical fluorescence intensity cannot be obtained. Moreover, since light from the light source is not sufficiently absorbed and much components of the light passes through the fluorescent conversion medium, the color purity becomes poor.

The preferable range of the value "C·d/r³" differs depending on the material for the semiconductor nanocrystals. For CdSe, since CdSe has a relatively large light absorption coefficient, the upper limit of the value "C·d/r³" must be decreased. In this case, it is preferable that "$0.4 < C·d/r^3 < 3.0$", and still more preferably "$0.5 < C·d/r^3 < 2.5$".

For InP, since InP has a relatively small light absorption coefficient, the upper limit of the value "C·d/r³" can be increased in comparison with CdSe. Inthiscase, it is preferable that "$0.5 < C·d/r^3 < 5.0$", and still more preferably "$1.5 < C·d/r^3 < 4.5$".

For ZnTe, since the light absorption coefficient thereof is not small but the band gap thereof is as great as 2.25 eV compared with those of CdSe and InP, ZnTe with a large particle diameter is necessary in order to obtain "visible absorption-visible fluorescence". Therefore, the upper limit of the value "C·d/r³" must be decreased. In this case, it is preferable that "$0.4 < C·d/r^3 < 2.0$", and still more preferably "$0.5 < C·d/r^3 < 2.0$".

The film thickness d of the fluorescent conversion medium may be arbitrarily adjusted depending on the volume ratio C and the particle diameter r of the fluorescent particles. The film thickness d is preferably 1 $\mu$m to 500 $\mu$m.

The diameter of the fluorescent particles in the fluorescent conversion medium may be calculated by photographing the cross section of the fluorescent conversion medium at two or more points using a transmission electron microscope, creating a particle size distribution curve from the resulting images, and performing statistical processing. The volume ratio C may also be calculated by statistical processing of transmission electron microscope images.

[Second Embodiment]

A color light emitting apparatus which is a second embodiment of the invention will be described below.

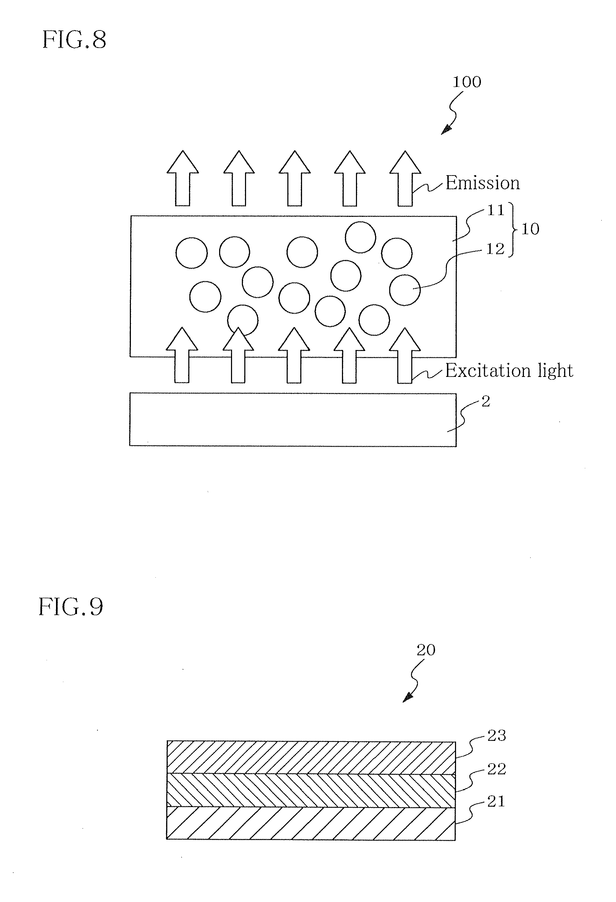

FIG. 8 is a diagram showing a color light emitting apparatus according to the second embodiment of the invention.

A color light emitting apparatus 100 includes a light source part 2 which emits visible light and a fluorescent conversion part 10 which receives light from the light source part 2 to emit a fluorescence having a longer wavelength. In this embodiment, the fluorescent conversion part 10 is the same as the fluorescent conversion medium of the first embodiment mentioned above.

As the light source part 2, there can be used a part which emits visible light. For example, an organic EL device, inorganic EL device, semiconductive light-emitting diode and fluorescent display tube can be used. Of these, preferred is EL device wherein a transparent electrode is provided on the light-outcoupling side. As specific preferable examples of such an EL device, an organic EL device and inorganic EL device including a light-reflecting electrode, emitting layer and counter transparent electrode with the emitting layer interposed between the light reflecting layer and the transparent electrode, can be given.

An organic EL device using a transparent electrode on the light-outcoupling side as a light source will be described below.

FIG. 9 is a diagram showing a configuration of an organic EL device.

An organic EL device 20 has a configuration wherein a light-reflecting electrode 21, organic luminescent medium 22 and transparent electrode 23 are stacked on a substrate (not shown) in this order.

Voltage is applied between the light-reflecting electrode 21 and the transparent electrode 23 so that electrons and holes are supplied to the organic luminescent medium 22, and electrons and holes are recombined to emit light. Light generated in the organic luminescent medium 22 is outcoupled from the transparent electrode 23, and light inside the EL device 20 can be outcoupled more efficiently to the outside by forming the light-reflecting electrode 21.

(1) Configuration of organic EL device

(a) Organic luminescent medium

The organic luminescent medium can be defined as a medium containing an organic emitting layer wherein electrons and holes are recombined with each other, thereby allowing EL emission. This organic luminescent medium can be made, for example, by stacking the following layers on an anode:

(i) Organic emitting layer
(ii) Hole-injecting layer/Organic emitting layer
(iii) Organic emitting layer/Electron-injecting layer
(iv) Hole-injecting layer/Organic emitting layer/Electron-injecting layer
(v) Organic semiconductor layer/Organic emitting layer
(vi) Organic semiconductor layer/Electron barrier layer/Organic emitting layer
(vii) Hole-injecting layer/Organic emitting layer/Adhesion improving layer

Among these, the structure (iv) is preferably used since it can give a higher luminance and is also superior in durability.

Examples of the luminescent material for the organic emitting layer in the organic luminescent medium include one or a combination of two or more selected from p-quaterphenyl derivatives, p-quinquphenyl derivatives, benzothiazole compounds, benzoimidazole compounds, benzoxazole compounds, metal-chelated oxinoid compounds, oxadiazole compounds, styrylbenzene compounds, distyrylpyrazine derivatives, butadiene compounds, naphthalimide compounds, perylene derivatives, aldazine derivatives, pyrazine derivatives, cyclopentadiene derivatives, pyrrolopyrrole derivatives, styrylamine derivatives, coumarin compounds, aromatic dimethylidyne compounds, metal complexes having a ligand of a 8-quinolynol derivative, and polyphenyl compounds.

Among these organic luminescent materials, 4,4'-bis (2,2-di-t-butylphenylvinyl) biphenyl (abbreviated to DTBPBBi) and 4,4'-bis(2,2-diphenylvinyl)biphenyl (abbreviated to DPVBi) as aromatic dimethylidyne compounds, and derivatives thereof are more preferred.

Furthermore, it is preferred to use together a material wherein an organic luminescent material having a distyrylarylene skeleton or the like, as a host material, is doped with a fluorescent dye giving intense blue and red fluorescence, for example, a coumarin material, or a fluorescent dye similar to the host, as a dopant. More specifically, it is preferred to use the above-mentioned DPVBi or the like as a host and use N,N-diphenylaminobenzene (abbreviated to DPAVB) as a dopant.

Compounds having a hole mobility of $1 \times 10^{-6}$ cm$^2$/v·s or more measured at an applied voltage of $1 \times 10^4$ to $1 \times 10^6$ V/cm and an ionization energy of 5.5 eV or less are preferably used in a hole injecting layer of an organic luminescent medium. Such a hole injecting layer enables good hole injection into an organic emitting layer, thereby enhancing a luminance or allowing low voltage drive.

Examples of such a constituent material for the hole injection layer include porphyrin compounds, aromatic tertiary amine compounds, styrylamine compounds, aromatic dimethylidine compounds, condensed aromatic ring compounds and organic compounds such as 4,4'-bis[N-(1-naphthyl)-N-phenylamino]biphenyl (abbreviated to NPD) and 4,4', 4"-tris [N-(3-methylphenyl)-N-phenylamino]triphenylamine (abbreviated to MTDATA).

Inorganic compounds such as p-type Si and p-type SiC are preferably used as a constituent material for the hole injection layer. It is also preferred that an organic semiconductor layer having an electrical conductivity of $1 \times 10^{-10}$ S/cm or more is formed between the above hole injecting layer and anode, or between the above hole injecting layer and organic emitting layer. Such an organic semiconductor layer enables better hole injection into an organic emitting layer.

Compounds having an electron mobility of $1 \times 10^{-6}$ cm$^2$/V· s or more measured at an applied voltage of $1 \times 10^4$ to $1 \times 10^6$ V/cm and an ionization energy more than 5.5 eV are preferably used in an electron injecting layer of an organic luminescent medium. Such an electron injecting layer enables good electron injection into an organic emitting layer, thereby enhancing a luminance or allowing low voltage drive. Examples of a constituent material for the electron injecting layer include metal complexes of 8-hydroxyxinoline (Al chelate: Alq), derivatives thereof or oxadiazole derivatives.

An adhesion improving layer in an organic luminescent medium is one kind of the electron injecting layer. That is, it is a layer comprising a material with good adhesion properties to a cathode among electron injecting layers. The adhesion improving layer is preferably made of metal complexes of 8-hydroxyxinoline or derivatives thereof. It is also preferred that an organic semiconductor layer with an electric conductivity of $1 \times 10^{-10}$ S/cm or more is formed in contact with the above electron injecting layer. Such an organic semiconductor layer enables good electron injecting into an organic emitting layer.

The thickness of the organic luminescent medium is preferably 5 nm to 5 $\mu$m. If the thickness is below 5 nm, the luminance and durability thereof may deteriorate, while if it exceeds 5 $\mu$m, an applying voltage may become high. Therefore, the thickness of the organic emitting layer is more preferably 10 nm to 3 $\mu$m, and still more preferably 20 nm to 1 $\mu$m.

(b) Light-reflecting electrode (first electrode)

The first electrode is a reflecting electrode which reflects light, and need not exhibit transparency. In the invention, the device configuration may be either a configuration in which the reflecting electrode is the anode and the transparent electrode described later is the cathode and a configuration in which the reflecting electrode is the cathode and the transparent electrode is the anode.

When using the first electrode as the anode, a metal having a work function required for hole injection is used. It is preferable that the metal have a work function of 4.6 eV or more. As specific examples of such a metal, metals such as gold, silver, copper, iridium, molybdenum, niobium, nickel, osmium, palladium, platinum, ruthenium, tantalum, tungsten, and aluminum, alloys thereof, metal oxides such as indium and/or tin oxide (hereinafter abbreviated as "ITO"), copper iodide, conductive polymers such as polypyrrole, polyaniline, and poly(3-methylthiophene), and laminates thereof can be given.

When using the first electrode as the cathode, a metal, an alloy, an electrically conductive compound, and a mixture thereof, having a small work function (less than 4.0 eV), is used as an electrode material. Specific examples of such an electrode material include one or a combination of two or more selected from sodium, sodium-potassium alloy, magnesium, lithium, magnesium-silver alloy, aluminum-aluminum oxide, aluminum-lithium alloy, indium, and rare earth metals.
(c) Transparent electrode (second electrode)

For the second electrode, transparent electrode materials of transparent conductive materials may be used. In order to efficiently outcouple light emitted from an emitting layer, the transparent electrode may be formed of materials with a transmittance of 10% or more, preferably 60% or more. Specific materials include only one or combinations of two or more selected from indium tin oxide (ITO), indium zinc oxide (IZO), copper indium (CuIn), tin oxide ($SnO_2$), zinc oxide (ZnO), antimony oxide ($Sb_2O_3$, $Sb_2O_4$, $Sb_2O_5$), aluminum oxide ($Al_2O_3$) and so on. In order to decrease the resistance thereof without damaging transparency, only one or combination of two or more selected from metals such as Pt, Au, Ni, Mo, W, Cr, Ta and Al is preferably added.

When using the second electrode as the cathode, a low-work-function layer formed of a low-work-function material for injecting electrons into an organic emitting layer may be used together. As the material for the low-work-function layer, a material having a small work function, for example less than 4.0 eV, is used due to easy electron injection. It is preferable to form the low-work-function layer on an organic luminescent medium to such a reduced thickness that the low-work-function layer exhibits sufficient transmittance, and to stack the transparent electrode on the low-work-function layer. This is because it is difficult to use a transparent oxide conductor such as ITO or ZnO as the cathode, since such a transparent oxide conductor has a work function of 4.6 eV or more.
As the low-work-functionmaterial, a metal such as aluminum, barium, calcium, cerium, erbium, europium, gadolinium, hafnium, indium, lanthanum, magnesium, silver, manganese, neodymium, scandium, samarium, yttrium, zinc, or zirconium, or an alloy of such a metal and another metal may be used. In particular, magnesium, silver, or an alloy of magnesium and silver is preferably used.
The thickness of the transparent electrode is generally 5 to 1000 nm, and preferably 10 to 500 nm. The thickness of the low-work-function layer is generally 1 to 100 nm, preferably 5 to 50 nm, and still more preferably 5 to 30 nm. If the thickness of each member exceeds the upper limit, light emitted from an organic emitting layer may not be efficiently outcoupled. If the thickness of each member is less than the lower limit, damage to an organic emitting layer may not be prevented when forming the transparent electrode layer.
For the method for forming each of the layers in the organic EL device of the invention, a known forming method, such as vacuum deposition, sputtering or spin coating can be used.
In the organic EL device mentioned above, a transparent medium which connects the transparent electrode to the fluorescent conversion medium may be formed, if necessary. The transparent medium is used in order to enhance the surface smoothness of fluorescent conversion medium.

As the transparent medium, inorganic materials, organic materials, multilayer structures thereof and the like may be used as long as the materials have a transmittance of 50% or more relative to visible light.
For the inorganic materials, an inorganic oxide layer, inorganic nitride layer or inorganic oxynitride layer is preferable. For example, silica, alumina, AlON, SiAlON, $SiN_x$ ($1 \leq x \leq 2$), $SiO_xN_y$ (preferably $0.1 \leq x \leq 1$, $0.1 \leq y \leq 1$) can be given.
For the organic materials, silicone gel, fluorohydrocarbon liquid, acryl resin, epoxy resin, silicone resin and the like can be used.
When using the inorganic materials, the transparent medium can be formed by sputtering, CVD, sol-gel and the like. When using the organic materials, it can be formed by spin coating, printing, drop filling and the like.
The thickness of the transparent medium is 0.01 $\mu$m to 10 mm, preferably 0.1 $\mu$m to 1 mm.

[Third Embodiment]

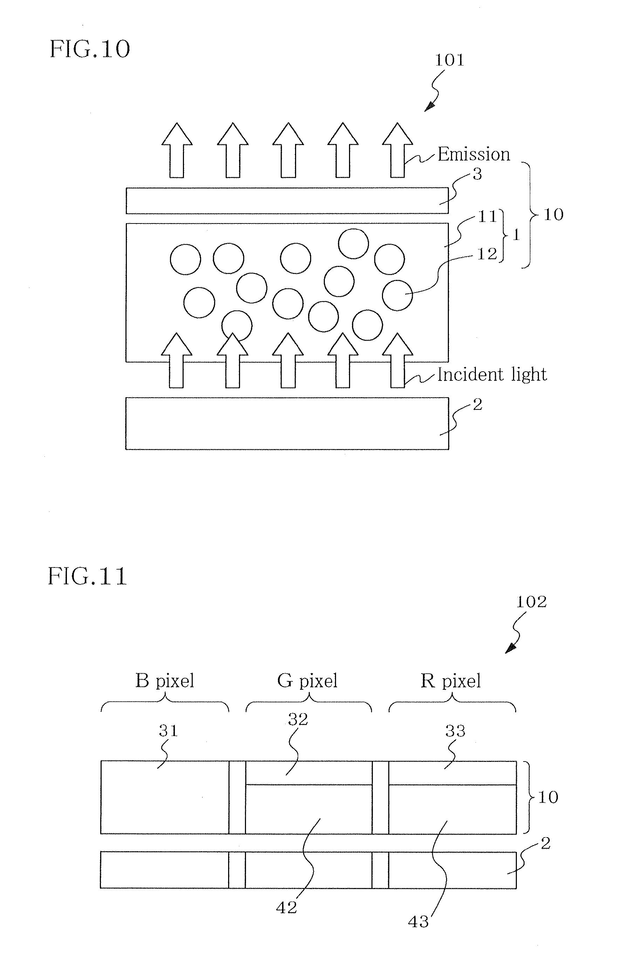

FIG. 10 is a diagram showing a color light emitting apparatus according to a third embodiment of the invention. A color light emitting apparatus 101 includes a light source part 2 which emits visible light and a fluorescent conversion part 10 which receives light from the light source part 2 to emit a fluorescence having a longer wavelength.

The fluorescent conversion part 10 is a multilayer structure of the fluorescent conversion medium 1 of the first embodiment and a color filter 3 which transmits a fluorescent component from the fluorescent conversion medium and cuts off the other light components.

The color filter 3 prevents a decrease in contrast ratio of the apparatus. The contrast ratio is a brightness ratio of the emitting state where the emitting apparatus 101 receives light from the outside, e.g., sunlight and room lighting, so that the fluorescent conversion medium 1 emits a fluorescence, to the non-emitting state.

Examples of materials for the color filter used in the invention include the following dyes only or solid objects in which a dye is dissolved or dispersed in a binder resin.

| | |
|---|---|
| Red (R) dye: | perylene pigment, lake pigment, azo pigment, diketopyrrolopyrrole pigment and the like |
| Green (G) dye: | halogen-multisubstituted phthalocyanine pigment, halogen-multisubstituted copper phthalocyanine pigment, basic triphenylmethane dye and the like |
| Blue (B) dye: | copper phthalocyanine pigment, indanthrone pigment, indophenol pigment, cyanine pigment and the like. |

The material for the binder resin is preferably transparent (transmittance of visible light: 50% or more). Examples of the binder resin include transparent resins (polymers) such as polymethyl methacrylate, polyacrylate, polycarbonate, polyvinyl alcohol, polyvinyl pyrrolidone, hydroxyethylcellulose, and carboxymethylcellulose, and photocurable resist materials having reactive vinyl groups such as acrylic acid type, methacrylic acid type, and the like, as photosensitive resins to which photolithography can be applied. When employing printing method, a print ink (medium) using a transparent resin such as polyvinyl chloride resin, melamine resin, or phenol resin may be selected.

When the color filter is mainly made of a dye, it may be formed by a vacuum deposition method or a sputtering method using a mask having a desired color filter pattern. When it is made of a dye and a binder resin, it is generally formed by the following method. The fluorescent dye, the above-described resin and a resist are mixed, dispersed, or dissolved. A film is formed from the mixture by spin coating, roll coating, casting, or the like. The resulting film is patterned into a desired color filter pattern by photolithography method. A color filter may be patterned into a desired color filter pattern by printing or the like. The thickness and the transmittance of each color filter are preferably set as follows.

R: thickness: 0.5 to 5.0 $\mu$m (transmittance: 50% or more at 610 nm)
G: thickness: 0.5 to 5.0 $\mu$m (transmittance: 50% or more at 545 nm)
B: thickness: 0.2 to 5.0 $\mu$m (transmittance: 50% or more at 460 nm)

In the invention, when providing a full color light emitting apparatus which emits light of red, green, and blue (three primary colors), a black matrix may be used to increase the contrast ratio.

[Fourth Embodiment]

FIG. 11 is a diagram showing a color light emitting apparatus according to a fourth embodiment of the invention. A color light emitting apparatus 102 includes a light source part 2 which emits light containing at least a blue component (wavelength: 430 nm to 490 nm) and a fluorescent conversion part 10 which receives light from the light source part 2 to emit and transmit light in each color in red (R), green (G) and blue (B).

The fluorescent conversion part 10 includes pixels of red (R), green (G) and blue (B). The red pixel includes a red fluorescent conversion medium 43 having the configuration mentioned above and a red color filter 33, and receives light from the light source part 2 to emit red light. Likewise, the green (G) pixel includes a green fluorescent conversion medium 42 and a green color filter 32, and receives light from the light source part 2 to emit green light.

The blue (B) pixel includes only a color filter 31, and transmits only a blue component of light emitted from the light source part 2 to emit blue light.

In this color light emitting apparatus 102, blue color is transmitted through the color filter without color-converting light of the light source, whereby forming a blue fluorescent conversion medium is not needed so as to obtain three primary colors required for a full color display, and a production process of an emitting device can be simplified.

As the constituent elements of this embodiment, the elements mentioned above in the first to third embodiments can be used. The each pixel can be formed by known methods.

In this embodiment, the red (R) and green (G) pixels are multilayer structures of fluorescent conversion mediums and color filters. They are not limited to the structure and both or any one of the pixels may be a monolayer structure of a fluorescent conversion medium.

[Fifth Embodiment]

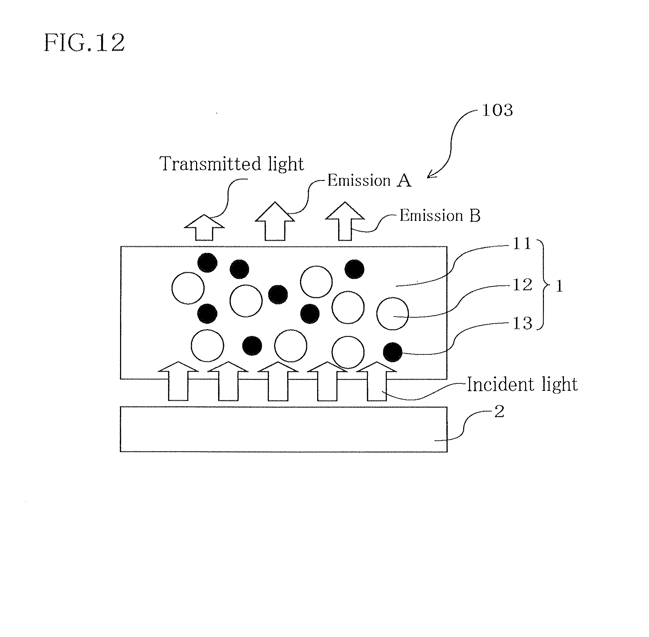

FIG. 12 is a diagram showing a color light emitting apparatus according to a fifth embodiment of the invention. A color light emitting apparatus 103 includes a light source part 2 which emits light containing at least a blue component (wavelength: 430 nm to 490 nm) and a fluorescent conversion part 1 which receives light from the light source part 2 to emit light in at least one color ranging from green to red and transmits a part of the blue component of light from the light source part 2.

The fluorescent conversion medium 1 is a film wherein fluorescent particles 12 and 13 are dispersed in a transparent medium 11. The fluorescent particles 12 and 13 absorb the excited light from the light source part 2 to emit light (fluorescence) of a longer wavelength in the region of green to red. The fluorescent particles 12 and 13 are different in particle diameter and material so that they can emit light in different colors, emission A and emission B.

The average diameter and volume ratio C of the combined fluorescent particles 12 and 13, and film thickness d of the fluorescent conversion medium are appropriately selected within a range of $0.4 < C \cdot d/r^3 < 5.0$, thereby transmitting part of blue light (transmitted light shown in the figure) emitted from the light source part 2.

A color light emitting apparatus which emits white light including well-balanced blue (transmitted light), green (emission A) and red (emission B) of light's three primary colors can be thus obtained.

The color light emitting apparatus of FIG. 12 includes two kinds of the different fluorescent particles 12 and 13. However only one kind of fluorescent particles emitting yellow light may be dispersed and the yellow light and blue light transmitted through the light source part may be combined to give white light.

[EXAMPLES]

The invention will be described with reference to examples hereinafter.

Example 1

1. Fabrication of light source

ITO was deposited on a glass substrate measuring 25 mm x 75 mm x 1.1 mm in a thickness of 130 nm by sputtering to form a transparent supporting substrate. The substrate was subjected to ultrasonic cleaning in isopropyl alcohol for 5 minutes, and then dried by spraying nitrogen thereon. The resultant substrate was cleaned with ultraviolet ozone (UV300, manufactured by Opto Films Lab) for 10 minutes.

The transparent supporting substrate was installed in a substrate holder of a vacuum deposition system (manufactured by ULVAC, Inc.) A molybdenum heating boat was charged with 200 mg of N,N'-bis(3-methylphenyl)-N,N'-diphenyl(1,1'-biphenyl)-4,4'-diamine (TPD), another molybdenum heating boat was charged with 200 mg of 4,4'-bis(2,2'-diphenylvinyl) biphenyl (DPVBi) and another molybdenum heating boat was charged with 200 mg of 4,4'-bis (2,4-N,N-diphenylaminophenylvinyl) biphenyl (DPAVBi) to reducing the pressure inside the vacuum chamber to $1\times10^{-4}$ Pa.

The boat charged with TPD was heated to 215 to 220°C and TPD was deposited on the transparent supporting substrate at a rate of 0.1 to 0.3 nm/s to form a 60 nm thick hole-injecting layer. The temperature of the substrate was room temperature. Without removing the substrate from the vacuum chamber, DPVBi as a host material was deposited in a thickness of 40 nm on the hole-injecting layer. At the same time, the boat charged with DPAVBi was heated and DPAVBi was mixed into the emitting layer as an emitting dopant. At this time, the deposition rate of DPAVBi of a dopant material was 0.1 to 0.13/s, while the deposition rate of DPAVBi of a host material was 2. 8 to 3.0 nm/s. Thereafter, the pressure inside the vacuum chamber was returned to atmosphere pressure. A molybdenum heating boat was charged with a 8-hydroxyquinoline·aluminum complex as the material of an adhesive layer and aluminum as a cathode material was provided on a tungsten filament. The pressure inside the vacuum chamber was reduced to $1\times10^{-4}$ Pa.

Next, the 8-hydroxyquinoline·aluminum complex was deposited at a rate of 0.01 to 0.03 nm/s to form a 20 nm thick adhesive layer. Aluminum was deposited to form a cathode in a thickness of 150 nm.

An organic EL source was thus obtained. A voltage of 7 V was applied to the light source obtained and the emission was measured with a spectral radiant luminance meter on the transparent supporting substrate side to determine blue green emission with a CIE chromaticity of (0.16, 0.30) and a luminance of 230 nit. The peak wavelength of the emission was 470 nm.

2. Fabrication of fluorescent conversion medium

(1) Fluorescent particles

As fluorescent particles, four kinds of semiconductor nanocrystals shown in Table 2 were prepared
Table 2

| Material | Particle diameter (nm) | Fluorescence wavelength (nm) |
|----------|------------------------|------------------------------|
| CdSe | 5.2 | 615 |
| InP | 4.9 | 616 |
| CdSe | 4.0 | 531 |
| ZnTe | 6.8 | 529 |

(2) Transparent medium solution to hold fluorescent particles dispersed

As a transparent medium, A methacrylic acid-methyl methacrylate copolymer (methacrylic acid copolymerization ratio: 15 to 20%, Mw: 20,000 to 25,000, refractive index: 1.60) was used and dissolved in 1-methoxy-2-acetoxypropane.

(3) Fabrication of color filter

A pigment-type red color filter material ("CRY-S840B" manufactured by FUJIFILM Arch Co., Ltd.) was applied by spin coating to a 0.7 mm thick glass substrate and was exposed to ultraviolet rays. The resulting product was baked at 200°C to obtain a red color filter layer (thickness: 1.2 $\mu$m) substrate.
A pigment-type green color filter material ("CG-8510L" manufactured by FUJIFILM Arch Co., Ltd.) was applied by spin coating to a 0.7 mm thick glass substrate and was exposed to ultraviolet rays. The resulting product was baked at 200°C to obtain a green color filter layer (thickness: 1.0 $\mu$m) substrate.

(4) Fabrication and evaluation of fluorescent conversion medium

CdSe particles, which emit red fluorescence having a fluorescence wavelength of 615 nm, having a particle diameter of 5.2 nm were added to a transparent medium solution so that the weight ratio of the CdSe particles to the total solid content was 36.7 wt%, and were subjected to dispersion treatment. The mixture was applied to the color filter film of the red color filter substrate previously prepared by spin coating, and dried at 200°C for 30 minutes to obtain a color conversion substrate in which the red color filter and the fluorescent conversion medium were stacked. The thickness of the fluorescent conversion medium was 10 $\mu$m.
The sectional view of the fluorescent conversion medium was observed with a transmission electron microscope and the volume ratio of the fluorescent particles to the medium was calculated. As a result, the volume ratio was 10 vol% and the value of $C \cdot d/r^3$ was 0.71.
The fluorescent conversion substrate was attached to the transparent supporting substrate with a silicone oil therebetween having a refractive index of 1.53 such that the fluorescent conversion medium faced the organic EL source. A voltage of 7 V was applied to the organic EL source part and the emission was measured with a spectral radiant luminance meter to determine good red emission with a CIE chromaticity of (0. 653, 0.345) and a luminance of 118 nit. The conversion efficiency defined as a ratio of the luminance after conversion to the luminance of the light source was a good value of 51.5%.

Example 2

A fluorescent conversion substrate was obtained in the same manner as in Example 1 except that the weight ratio of the CdSe particles to the total solid content was 28.2 wt% and the thickness of the fluorescent conversion medium was 20 $\mu$m.
The volume ratio of the fluorescent particles to the medium was 7 vol% and the value of $C \cdot d/r^3$ was 1.00.
The fluorescent conversion properties were evaluated in the same manner as in Example 1. The emission was good red emission with a CTE chromaticity of (0.655, 0.344) andaluminance of 122 nit. The conversion efficiency was a good value of 52.9%.

Example 3

A fluorescent conversion substrate was obtained in the same manner as in Example 1 except that the weight ratio of the CdSe particles to the total solid content was 31.2 wt% and the thickness of the fluorescent conversion medium was 50 $\mu$m.
The volume ratio of the fluorescent particles to the medium was 8 vol% and the value of $C \cdot d/r^3$ was 2.84.
The fluorescent conversion properties were evaluated in the same manner as in Example 1. The emission was good red emission with a CTE chromaticity of (0. 659, 0.341) and a luminance of 74 nit. The conversion efficiency was a good value of 32.1%.

Comparative example 1

A fluorescent conversion substrate was obtained in the same manner as in Example 1 except that the weight ratio of the CdSe particles to the total solid content was 34.0 wt% and the thickness of the fluorescent conversion medium was 5 $\mu$m.
The volume ratio of the fluorescent particles to the medium was 9 vol% and the value of $C \cdot d/r^3$ was 0.32.
The fluorescent conversion properties were evaluated in the same manner as in Example 1. The emission was red emission with a CIE chromaticity of (0.643, 0.352) and a luminance of 97 nit. The conversion efficiency was a good value of 42.3%. However, the y-coordinate value of the CIE chromaticity could not be below 0.35 and the emission was not sufficient red.

Comparative example 2

A fluorescent conversion substrate was obtained in the same manner as in Example 1 except that the weight ratio of the CdSe particles to the total solid content was 47.9 wt% and the thickness of the fluorescent conversion medium was 50 $\mu$m.
The volume ratio of the fluorescent particles to the medium was 15 vol% and the value of $C \cdot d/r^3$ was 5.33.
The fluorescent conversion properties were evaluated in the same manner as in Example 1. The emission was red emission with a CIE chromaticity of (0.660, 0.340) and a luminance of 31 nit. The conversion efficiency was a low value of 13.7%.

Example 4

CdSe particles, which emit green fluorescence having a fluorescence wavelength of 531 nm, having a particle diameter of 4.0 nm were added to a transparent medium solution so that the weight ratio of the CdSe particles to the total solid content was 21.5 wt%, and were subjected to dispersion treatment. The mixture was applied to the color filter film of the green color filter substrate previously prepared by spin coating, and dried at 200°C for 30 minutes to obtain a color conversion substrate in which the green color filter and the fluorescent conversion medium were stacked. The thickness of the fluorescent conversion medium was 10 $\mu$m.
The volume ratio of the fluorescent particles to the medium was 5 vol% and the value of $C \cdot d/r^3$ was 0.78.
The fluorescent conversion substrate was attached to the transparent supporting substrate with a silicone oil therebetween having a refractive index of 1.53 such that the fluorescent conversion medium faced the organic EL source. A voltage of 7 V was applied to the organic EL source part and the emission was measured with a spectral radiant luminance meter to determine good green emission with a CIE chromaticity of (0.219, 0.667) and a luminance of 248 nit. The conversion efficiency defined as a ratio of the luminance after conversion to the luminance of the light source was a good value of 108%.

Example 5

A fluorescent conversion substrate was obtained in the same manner as in Example 4 except that the weight ratio of the CdSe particles to the total solid content was 17.9 wt% and the thickness of the fluorescent conversion medium was 50 $\mu$m.
The volume ratio of the fluorescent particles to the medium was 4 vol% and the value of $C \cdot d/r^3$ was 3.13.
The fluorescent conversion properties were evaluated in the same manner as in Example 4, the emission was good green emission with a CIE chromaticity of (0.266, 0.691) andaluminance of 152 nit. The conversion efficiency was a good value of 65. 9%.

Comparative example 3

A fluorescent conversion substrate was obtained in the same manner as in Example 4 except that the weight ratio of the CdSe particles to the total solid content was 21.5 wt% and the thickness of the fluorescent conversion medium was 5 $\mu$m.
The volume ratio of the fluorescent particles to the medium was 5 vol% and the value of $C \cdot d/r^3$ was 0.39.
The fluorescent conversion properties were evaluated in the same manner as in Example 4, the emission had a CIE chromaticity of (0.203, 0.626) and a luminance of 229 nit. The conversion efficiency was a good value of 99.6%. However, the y-coordinate value of the CIE chromaticity was a low value of 0.626 and the emission was not sufficient green.

Comparative example 4

A fluorescent conversion substrate was obtained in the same manner as in Example 4 except that the weight ratio of the CdSe particles to the total solid content was 28.2 wt% and the thickness of the fluorescent conversion medium was 50 $\mu$m.
The volume ratio of the fluorescent particles to the medium was 7 vol% and the value of $C \cdot d/r^3$ was 5.47.
The fluorescent conversion properties were evaluated in the same manner as in Example 4, the emission had a CIE chromaticity of (0.317, 0.656) and a luminance of 80 nit. The conversion efficiency was a low value of 34.8%. The x-coordinate value of the CIE chromaticity was a large value of 0.317 and the emission was not sufficient green.

Example 6

InP particles, which emit red fluorescence having a fluorescence wavelength of 616 nm, having a particle diameter of 4.9 nm were added to a transparent medium solution so that the weight ratio of the InP particles to the total solid content was 32.6 wt%, and were subjected to dispersion treatment. The mixture was applied to the color filter film of the red color filter substrate previously prepared by spin coating, and dried at 200°C for 30 minutes to obtain a color conversion substrate in which the red color filter and the fluorescent conversion medium were stacked. The thickness of the fluorescent conversion medium was 20 $\mu$m.
The volume ratio of the fluorescent particles to the medium was 10 vol% and the value of $C \cdot d/r^3$ was 1.70.
The fluorescent conversion substrate was attached to the transparent supporting substrate with a silicone oil therebetween having a refractive index of 1.53 such that the fluorescent conversion medium faced the organic EL source. A voltage of 7 V was applied to the organic EL source part and the emission was measured with a spectral radiant luminance meter to determine good red emission with a CIE chromaticity of (0.654, 0.344) and a luminance of 112 nit. The conversion efficiency was a good value of 48.9%.

Example 7

A fluorescent conversion substrate was obtained in the same manner as in Example 6 except that the thickness of the fluorescent conversion medium was 50 $\mu$m.
The volume ratio of the fluorescent particles to the medium was 10 vol% and the value of $C \cdot d/r^3$ was 4.25.
The fluorescent conversion properties were evaluated in the same manner as in Example 4, the emission was good red emission with a CIE chromaticity of (0.660, 0.340) and a luminance of 98 nit. The conversion efficiency was a good value of 42.7%.

Comparative example 5

A fluorescent conversion substrate was obtained in the same manner as in Example 6 except that the weight ratio of the InP particles to the total solid content was 15.4 wt% and the thickness of the fluorescent conversion medium was 10 $\mu$m.
The volume ratio of the fluorescent particles to the medium was 4 vol% and the value of $C \cdot d/r^3$ was 0.34.
The fluorescent conversion properties were evaluated in the same manner as in Example 4, the emission had a CIE chromaticity of (0.622, 0.362) and a luminance of 65 nit. The conversion efficiency was a low value of 28.4%. The x-coordinate value of the CIE chromaticity was a low value of 0.622 and the y-coordinate value of the CIE chromaticity was a large value of 0.362. The emission was not sufficient red.

Comparative example 6

A fluorescent conversion substrate was obtained in the same manner as in Example 6 except that the weight ratio of the InP particles to the total solid content was 39.4 wt% and the thickness of the fluorescent conversion medium was 50 $\mu$m.

The volume ratio of the fluorescent particles to the medium was 13 vol% and the value of C·d/r$^3$ was 5.52.

The fluorescent conversion properties were evaluated in the same manner as in Example 4, the emission had a CIE chromaticity of (0.661, 0.339) and a luminance of 82 nit. The conversion efficiency was a low value of 35.7%.

Example 8

ZnTe particles, which emit green fluorescence having a fluorescence wavelength of 529 nm, having a particle diameter of 6.8 nm were added to a transparent medium solution so that the weight ratio of the ZnTe particles to the total solid content was 39.9 wt%, and were subjected to dispersion treatment. The mixture was applied to the color filter film of the green color filter substrate previously prepared by spin coating, and dried at 200°C for 30 minutes to obtain a color conversion substrate in which the green color filter and the fluorescent conversion medium were stacked. The thickness of the fluorescent conversion medium was 20 $\mu$m.

The volume ratio of the fluorescent particles to the medium was 11 vol% and the value of C·d/r$^3$ was 0.70.

The fluorescent conversion substrate was attached to the transparent supporting substrate with a silicone oil therebetween having a refractive index of 1.53 such that the fluorescent conversion medium faced the organic EL source. A voltage of 7 V was applied to the organic EL source part and the emission was measured with a spectral radiant luminance meter to determine good green emission with a CIE chromaticity of (0.211, 0.658) and a luminance of 222 nit. The conversion efficiency defined as a ratio of the luminance after conversion to the luminance of the light source was a good value of 96.7%.

Example 9

A fluorescent conversion substrate was obtained in the same manner as in Example 8 except that the thickness of the fluorescent conversion medium was 50 $\mu$m.

The volume ratio of the fluorescent particles to the medium was 11 vol% and the value of C·d/r$^3$ was 1.75.

The fluorescent conversion properties were evaluated in the same manner as in Example 8, the emission was good green emission with a CIE chromaticity of (0.237, 0.692) and a luminance of 187 nit. The conversion efficiency was a good value of 81.4%.

Comparative example 7

A fluorescent conversion substrate was obtained in the same manner as in Example 8 except that the weight ratio of the ZnTe particles to the total solid content was 25.5 wt% and the thickness of the fluorescent conversion medium was 20 $\mu$m.

The volume ratio of the fluorescent particles to the medium was 6 vol% and the value of C·d/r$^3$ was 0.38.

The fluorescent conversion properties were evaluated in the same manner as in Example 8, the emission had a CIE chromaticity of (0.198, 0.622) and a luminance of 220 nit. A conversion efficiency was a good value of 95.6%. However, the x-coordinate and y-coordinate values of the CIE chromaticity were low and the emission was not sufficient green.

Comparative example 8

A fluorescent conversion substrate was obtained in the same manner as in Example 8 except that the weight ratio of the ZnTe particles to the total solid content was 72.6 wt% and the thickness of the fluorescent conversion medium was 50 $\mu$m.

The volume ratio of the fluorescent particles to the medium was 33 vol% and the value of C·d/r$^3$ was 5.25.

The fluorescent conversion properties were evaluated in the same manner as in Example 8, the emission had a CIE chromaticity of (0.327, 0.647) and a luminance of 54 nit. The conversion efficiency was a low value of 23.4%. The x-coordinate value of the CIE chromaticity was a large value and the emission was not sufficient green.

Table 3 shows the parameters, conversion efficiencies and chromaticities of fluorescent conversion mediums fabricated in Examples and Comparative examples mentioned above.

Table 3

| | Material | Particle diameter r (nm) | Fluorescence wavelength (nm) | Weight ratio (wt%) | Thickness d (μm) | Volume ratio C (vol%) | $C \times d/r^3$ | Conversion efficiency (%) | Chromaticity CIEx | Chromaticity CIEy |
|---|---|---|---|---|---|---|---|---|---|---|
| Example 1 | CdSe | 5.2 | 615 | 36.7 | 10 | 10 | 0.71 | 51.5 | 0.653 | 0.345 |
| Example 2 | CdSe | 5.2 | 615 | 28.2 | 20 | 7 | 1.00 | 52.9 | 0.655 | 0.344 |
| Example 3 | CdSe | 5.2 | 615 | 31.2 | 50 | 8 | 2.84 | 32.1 | 0.659 | 0.341 |
| Comparative Example 1 | CdSe | 5.2 | 615 | 34.0 | 5 | 9 | 0.32 | 42.3 | 0.643 | 0.352 |
| Comparative Example 2 | CdSe | 5.2 | 615 | 47.9 | 50 | 15 | 5.33 | 13. 7 | 0.660 | 0.340 |
| Example 4 | CdSe | 4 | 531 | 21.5 | 10 | 5 | 0.78 | 108.0 | 0.219 | 0.667 |
| Example 5 | CdSe | 4 | 531 | 17.9 | 50 | 4 | 3.13 | 65.9 | 0.266 | 0.691 |
| Comparative Example 3 | CdSe | 4 | 531 | 21.5 | 5 | 5 | 0.39 | 99.6 | 0.203 | 0.626 |
| Comparative Example 4 | CdSe | 4 | 531 | 28.2 | 50 | 7 | 5.47 | 34.8 | 0.317 | 0.656 |
| Example 6 | InP | 4.9 | 616 | 32.6 | 20 | 10 | 1.70 | 48.9 | 0.654 | 0.344 |
| Example 7 | InP | 4.9 | 616 | 32.6 | 50 | 10 | 4.25 | 42.7 | 0.660 | 0.340 |
| Comparative Example 5 | InP | 4.9 | 616 | 15.4 | 10 | 4 | 0.34 | 28.4 | 0.622 | 0.362 |
| Comparative Example 6 | InP | 4.9 | 616 | 39.4 | 50 | 13 | 5.52 | 35.7 | 0.661 | 0.339 |
| Example 8 | ZnTe | 6.8 | 529 | 39.9 | 20 | 11 | 0.70 | 96.7 | 0.211 | 0.658 |
| Example 9 | ZnTe | 6.8 | 529 | 39.9 | 50 | 11 | 1.75 | 81.4 | 0.237 | 0.692 |
| Comparative Example 7 | ZnTe | 6.8 | 529 | 25.5 | 20 | 6 | 0.38 | 95.6 | 0.198 | 0.622 |
| Comparative Example 8 | ZnTe | 6.8 | 529 | 72.6 | 50 | 33 | 5.25 | 23.4 | 0.327 | 0.647 |

Industrial Applicability

The luminescent conversion medium and the color light emitting apparatus with the medium according to the invention can be used for various displays such as TVs, large-screen displays, and displays for portable telephones.

**Claims**

1.  A fluorescent conversion medium comprising:

    fluorescent particles comprising semiconductor nanocrystals, the particles absorbing visible light to emit fluorescence of a different wavelength,
    a transparent medium holding the fluorescent particles dispersed therein, and
    satisfying $0.4 < C \cdot d/r^3 < 5.0$

    wherein r is the average diameter (unit: nm) of the fluorescent particles, d is the film thickness (unit: $\mu$m) of the fluorescent conversion medium, and C is the volume ratio (unit: vol%) of the fluorescent particles to the fluorescent conversion medium.

2.  The fluorescent conversion medium according to claim 1, wherein a bulk material used for the semiconductor nanocrystals has a band gap of 1.0 to 3.0 eV at 20°C.

3.  The fluorescent conversion medium according to claim 1, wherein the fluorescent particles are core/shell semiconductor nanocrystals comprising a core particle made of a semiconductor nanocrystal and a shell layer made of a second semiconductor material having a larger band gap than the band gap of the semiconductor material used for the core particle.

4.  The fluorescent conversion medium according to claim 3, wherein the transparent medium is a resin, and the surface of the shell layer is subjected to a compatibility-treatment to enhance the affinity to the resin.

5.  A fluorescent conversion substrate comprising;
    a transparent support substrate, and
    a fluorescent conversion part provided on the transparent support substrate, the part comprising the fluorescent conversion medium according to claim 1.

6.  A color light emitting apparatus comprising;
    a light source emitting visible light, and
    a fluorescent conversion part receiving the light from the light source to emit fluorescence of a longer wavelength, the part comprising the fluorescent conversion medium according to claim 1.

7.  The color light emitting apparatus according to claim 6, wherein the fluorescent conversion part is a multilayer structure of the fluorescent conversion medium and a color filter, the color filter transmitting light in a wavelength region of the fluorescence from the fluorescent conversion medium, and cutting off light in the other wavelength region.

8.  A color light emitting apparatus comprising;
    a light source emitting at least blue light, and
    a fluorescent conversion part comprising pixels of red (R), green (G) and blue (B), the part receiving light from the light source to emit red, green or blue light,
    the pixels of red (R) and green (G) comprising the fluorescent conversion medium according to claim 1, and
    the pixel of blue (B) comprising a color filter.

9.  A color light emitting apparatus comprising;
    a light source emitting at least blue light, and
    the fluorescent conversion medium according to claim 1 receiving light from the light source to emit light in at least one color ranging from green to red and transmit part of the blue light emitted from the light source.

10. The color light emitting apparatus according to claim 6, 8 or 10, wherein the light source is an organic electroluminescent device,

the organic electroluminescent device comprising,
a first light-reflective electrode,
a second transparent electrode, and
an organic luminescent medium comprising an organic emitting layer between the first and second electrodes.

FIG.1

Transmitted light
+Fluorescence

1

11

12

Excitation light

FIG.2

1

a:Fluorescence

11

12

Excitation light

FIG.3

FIG.4

FIG.5

FIG.6

FIG.7A

FIG.7B

FIG.7C

FIG.7D

FIG.8

FIG.9

FIG.10

101

Emission

3

11
12
} 1

10

Incident light

2

FIG.11

102

B pixel

G pixel

R pixel

31

32

33

10

2

42

43

FIG.12

<table>
<tr><td colspan="2">**INTERNATIONAL SEARCH REPORT**</td><td colspan="2">International application No.<br>PCT/JP2005/004225</td></tr>
</table>

**A. CLASSIFICATION OF SUBJECT MATTER**
Int.Cl⁷ C09K11/02, 11/08, H05B33/12, 33/14

According to International Patent Classification (IPC) or to both national classification and IPC

**B. FIELDS SEARCHED**

Minimum documentation searched (classification system followed by classification symbols)
Int.Cl⁷ C09K11/02, 11/08, H05B33/12, 33/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2004-83653 A (Sharp Corp.),<br>18 March, 2004 (18.03.04),<br>Full text<br>& US 2004/105481 A1 | 1-10 |
| Y | JP 2002-510866 A (Massachusetts Institute of Technology),<br>09 April, 2002 (09.04.02),<br>Full text; particularly, examples<br>& WO 99/50916 A1          & EP 1070355 A1<br>& US 6501091 B1 | 1-10 |

☒ Further documents are listed in the continuation of Box C.     ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>08 June, 2005 (08.06.05) | Date of mailing of the international search report<br>28 June, 2005 (28.06.05) |
|---|---|
| Name and mailing address of the ISA/<br>Japanese Patent Office | Authorized officer |
| Facsimile No. | Telephone No. |

Form PCT/ISA/210 (second sheet) (January 2004)

| INTERNATIONAL SEARCH REPORT | | International application No. |
|---|---|---|
| | | PCT/JP2005/004225 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2003-505330 A  (Massachusetts Institute of Technology), 12 February, 2003 (12.02.03), Full text; particularly, examples & WO 2001/7689 A2        & EP 1250474 A2 & US 6607829 B1 | 1-10 |

Form PCT/ISA/210 (continuation of second sheet) (January 2004)

**EP 1 731 583 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3152897 A
- JP 8286033 A
- JP 2000256565 A
- JP 2003231450 A
- US 6608439 B
- US 6501091 B
- JP 2002510866 T